# FASCICULE DE BREVET EUROPEEN

(11) **EP 1 606 429 B1**
(45) Date de publication et mention de la délivrance du brevet: **26.12.2007**
(21) Numéro de dépôt: 04742294.4
(22) Date de dépôt: 19.03.2004
(51) Int. Cl.: C23C 16/18

(54) **PROCEDE POUR LE DEPOT PAR CVD D'UN FILM D ARGENT SUR UN SUBSTRAT**
VERFAHREN ZUR CVD-ABSCHEIDUNG EINES SILBERFILMS AUF EINEM SUBSTRAT
METHOD FOR CVD DEPOSITION OF A SILVER FILM ON A SUBSTRATE

(30) Priorité: 25.03.2003 FR 0303613
(43) Date de publication de la demande: 21.12.2005
(73) Titulaire: CENTRE NATIONAL DE LA RECHERCHE SCIENTIFIQUE (CNRS), 75016 Paris (FR); Qualiflow, 34000 Montpellier (FR)
(72) Inventeur: DECAMS, Jean-Manuel, F-34090 Montpellier (FR); GUILLON, Hervé, F-34090 Montpellier (FR); DOPPELT, Pascal, F-93130 Noisy-le-Sec (FR)
(74) Mandataire: Sueur, Yvette
(86) Numéro de dépôt international: PCT/FR2004/000678
(87) Numéro de publication internationale: WO 2004/087988

(56) Documents cités:
- KUZMINA N. ET AL: "Silver pivalate as a new volatile precursor for thin film deposition" JOURNAL DE PHYSIQUE IV (PROCEEDINGS), vol. 9, 1999, pages 923-928, XP001154782 France
- EDWARDS DENIS A. ET AL: "Aerosol-assisted chemical vapour deposition (AACVD) of silver films from triorganophosphine adducts of silver carboxylates..." INORGANICA CHIMICA ACTA, vol. 328, 2002, pages 134-146, XP002261244
- SZLYK E ET AL: "CVD OF AGI COMPLEXES WITH TERTIARY PHOSPHINES AND PERFLUORINATED CARBOXYLATES - A NEW CLASS OF SILVER PRECURSORS" CHEMICAL VAPOR DEPOSITION, VCH PUBLISHERS, WEINHEIM, DE, vol. 7, no. 3, 1 mai 2001 (2001-05-01), pages 111-116, XP001005129 ISSN: 0948-1907
- PARAMONOV N. ET AL: "MOCVD of Ag Thin Films" JOURNAL DE PHYSIQUE IV: PROCEEDINGS, vol. 11, no. Pr3, 2001, pages 645-652, XP009021057
- SZLYK E ET AL: "AU AND AG COMPLEXES WITH TERTIARY PHOSPHINES AND PERFLUORINATED CARBOXYLATES AS PRECURSORS FOR CVD OF GOLD AND SILVER" CHEMICAL VAPOR DEPOSITION, VCH PUBLISHERS, WEINHEIM, DE, vol. 6, no. 3, juin 2000 (2000-06), pages 105-108, XP000927907 ISSN: 0948-1907

## Description

La présente invention concerne le dépôt de films minces d'argent sur divers substrats, notamment sur des substrats supraconducteurs.

L'argent est un métal peu oxydable, chimiquement assez stable, qui présente des propriétés électriques remarquables. C'est en effet le métal le plus conducteur qui soit connu (p = 1.57 µΩ.cm). C' est pourquoi son utilisation sous forme de film mince présente de nombreux avantages dans le domaine des supraconducteurs à haute température critique Tc et en microélectronique. Pour les supraconducteurs hautes Tc, il a été montré qu'une couche métallique et en particulier une couche d'argent placée directement au-dessus ou en-dessous du matériau supraconducteur améliorait de façon significative la durée de vie du dispositif, câble ou ruban. Dans le domaine de la microélectronique et des écrans plats (technologie TFT = Thin Film Transistors), l'argent peut être utilisé en connectique dans les composants électroniques en remplacement de l'aluminium ou du cuivre actuellement utilisé.

Il existe divers procédés pour obtenir un dépôt d'argent sur un substrat.

Un procédé consistant à faire une évaporation flash de pivalate d'argent sous forme solide a été décrit par S. Samiolenkov, et al., (Chem. Vap. Déposition, 2002, 8, n° 2, 74). Cependant, la température requise pour évaporer le pivalate est au moins égale à la température de décomposition, ce qui génère des pertes de produit et un mauvais rendement.

D'autres composés ont été utilisés pour faire des dépôts d'Ag par CVD. Ainsi l'utilisation de complexes (1,1,1,5,5,5-hexafluoro-2,4-pentanedionato) argent [bis-(triméthylsilyl)acétylène, a été décrite par Chi, Kai-Ming, et al., [Chem. Vap. Déposition (2001), 7, n° 3, 117-120]. L'utilisation de précurseurs d'argent du type β-dicétonate fluoré pour déposer des films d'argent par CVD a été décrite notamment dans JP-08053470. US-5096737 décrit des précurseurs pour le dépôt par CVD de films de divers métaux sur un substrat. Les précurseurs sont du type (COD)M(I)(hfacac), M étant Cu, Ag, Rh, Ir. Toutefois, dans tous ces procédés, l'utilisation de précurseurs fluorés risque d'introduire du fluor dans les couches d'argent déposées.

Des procédés utilisant des solutions de précurseurs ont été décrits notamment par J-P Sénateur, et al., ("Pulsed Injection MOCVD of Functional Electronic Oxides", Adv. Mater. Opt. Electron, 10, 155, 2000) et par H. Guillon, et al., ("Injection MOCVD, historical and state of the art", Multimetox Network Newsletter, Issue 4, November 2001, p. 3). Ces techniques ne peuvent toutefois être utilisées que pour des dépôts de métaux pour lesquels il existe des précurseurs solubles dans des solvants utilisables en CVD. Or les complexes d'argent non fluorés décrits dans l'art antérieur sont généralement peu solubles dans de tels solvants.

Le but de la présente invention est de proposer un procédé de dépôt d'une couche d'argent sur un substrat, par un choix approprié de réactifs permettant la dissolution d'un précurseur d'argent dans un solvant utilisable en CVD.

Le procédé selon l'invention pour le dépôt d'un film d'Ag sur un substrat consiste à effectuer un dépôt d'argent par CVD sur ledit substrat à l'aide d'une solution de précurseur d'argent. Il est caractérisé en ce que :
- le précurseur d'argent est un carboxylate d'argent RCO₂Ag dans lequel R est un radical alkyle linéaire ou ramifié ayant de 3 à 7 atomes des carbone, utilisé sous forme d'une solution dans un liquide organique ;
- la concentration en précurseur de la solution est entre 0,01 et 0, 6 mol/l ; et elle reste inférieure à la concentration à saturation
- Le liquide organique comprend une amine et/ou un nitrile, et éventuellement un solvant dont la température d'évaporation est inférieure à la température de décomposition du précurseur ;
- le pourcentage en volume de l'amine et/ou du nitrile dans le liquide organique est supérieur à 0,1 %.
- il est mis en oeuvre sous atmosphère d'oxygène ou sous atmosphère d'hydrogène.

Parmi les précurseurs d'argent, le pivalate d'argent (CH₃)₃-C-CO₂Ag est particulièrement préféré. Sa température de décomposition est de 200 °C.

Parmi les solvants, on préfère les composés organiques qui sont liquides à température ambiante et jusqu'à environ 200°C dans les conditions normales de pression. A titre d'exemple, on peut citer le mésitylène, le cyclohexane, le xylène, le toluène et le n-octane.

L'amine peut être choisie parmi les monoamines primaires, secondaires ou tertiaires, ou parmi les polyamines. A titre d'exemple de monoamines, on peut citer la n-hexylamine, l'isobutylamine, la disecbutylamine, la triéthylamine, la benzylamine, l'éthanolamine et la diisopropylamine. Comme exemples de polyamines, on peut citer la tétraméthyléthylènediamine.

Le nitrile peut être choisi parmi l'acétonitrile, le valéronitrile, le benzonitrile et le propionitrile.

Parmi les liquides organiques, on préfère tout particulièrement les mélanges de mésitylène avec la n-hexylamine, l'isobutylamine, la diisopropylamine, la triéthylamine, l'acétonitrile, le benzonitrile ou le valéronitrile, les mélanges de propionitrile avec l'hexylamine, l'isobutylamine, la diisopropylamine ou la benzylamine, les mélanges de cyclohexane avec l'hexylamine, l'isobutylamine, la diisopropylamine ou la disecbutylamine.

Le substrat sur lequel la couche d'argent est déposée peut être un matériau supraconducteur à haute T_{c}, une céramique dense ou une céramique poreuse, un polymère thermorésistant, un verre, MgO, LaAlO₃, Ni, Si, AsGa, InP, SiC et SiGe.

Le procédé permet d'obtenir des dépôts d'argent ayant une épaisseur jusqu'à 800 nm.

Lors de la mise en oeuvre du procédé de dépôt de couches d'argent sur un support, la composition contenant le précurseur d'argent est envoyée dans un dispositif de vaporisation par l'intermédiaire duquel elle est introduite dans une enceinte de dépôt à température élevée qui contient le support sur lequel la couche d'argent doit être déposée. Avant son arrivée dans le dispositif de vaporisation, la composition est généralement maintenue dans un réservoir à température ambiante. La vaporisation de la composition de précurseur peut être effectuée à l'aide de divers dispositifs connus de l'homme de métier. A titre d'exemple préféré, on peut citer le dispositif décrit dans Chem. Mat. 13, 3993 (2001), commercialisé par la société Jipelec sous le nom de "InJect Système d'injection et d'évaporation de précurseurs liquides purs ou sous forme de solutions". La température du substrat à revêtir et la température dans l'enceinte de dépôt est entre 200 et 450°C. L'enceinte de dépôt est sous atmosphère d'oxygène ou sous atmosphère d'hydrogène et sous une pression inférieure ou égale à 15 Torr. L'hydrogène ou l'oxygène peuvent être introduit dans l'enceinte de dépôt sous forme d'un mélange avec N₂ dans lequel le rapport en volume H₂/N₂ ou O₂/N₂ est inférieur ou égal à 1.

Un plasma froid peut éventuellement être ajouté autour du support. Lorsque le dépôt est effectué en présence de plasma, il est suffisant que le support destiné à recevoir la couche d'argent soit maintenu à la même température qui règne dans l'évaporateur. En l'absence de plasma, il est nécessaire que ledit support soit à une température supérieure à celle de l'évaporateur, la différence de température étant au moins égale à 20°C, de préférence au moins égale à 50°C, afin d'éviter le dépôt d'argent sur les parois de réacteur. La couche d'argent peut être déposée sur le support comme première couche ou comme n^{ème} couche de métallisation pour les dispositifs électroniques nécessitant plusieurs niveaux de métallisation. Le support peut être constitué par l'un des matériaux précités pris tel quel, ou bien par l'un de ces matériaux portant une ou plusieurs couches intermédiaires. A titre d'exemple de couches intermédiaires, on peut citer les films métalliques (par exemple un film de Ni), une couche organique (par exemple un couche d'un matériau polymère), ou les couches de diffusion constituées par un matériau choisi par exemple parmi TiN, TiSiN, Ta, TaN, TaSiN, WN et WSiN.

L'épaisseur de la couche d'argent qui se dépose sur le support dépend de la concentration de la composition de précurseur, du débit de cette composition lors du passage dans le dispositif de vaporisation, de la durée de la vaporisation, des températures respectives dans le réacteur et sur le support. De manière générale, on utilise des compositions moins concentrées et/ou de débits plus faibles pour l'obtention de couches fines, et des compositions plus concentrées et/ou des débits plus élevés pour l'obtention de couches épaisses. Par couche fine, on entend généralement une couche ayant une épaisseur inférieure à ou égale à 50 nm, dite couche de nucléation. Par couche épaisse, on entend généralement une couche ayant une épaisseur entre 50 nm et 1 µm.

Pour l'obtention de couches épaisses, l'on peut utiliser les compositions dans un solvant à coefficient de dissolution élevée, à une concentration en précurseur proche de la saturation. La concentration doit rester inférieure à la valeur à saturation, afin d'éviter la reprécipitation du précurseur qui aurait pour effet de gêner la vaporisation.

Pour l'obtention de couches minces, on peut utiliser les solvants dans lesquels la solubilité du précurseur est plus faible. On peut également utiliser un liquide organique non solvant du précurseur et chimiquement inerte vis-à-vis du précurseur pour diluer une composition de précurseur selon l'invention.

La mise en oeuvre du procédé de l'invention pour le dépôt de couches d'argent par CVD permet d'obtenir des couches d'argent de bonne qualité ayant une bonne adhérence au support sur lequel elles sont déposées.

La présente invention est illustrée plus en détail par les exemples suivants, auxquels elle n'est cependant pas limitée.

Les exemples ont été réalisés à l'aide d'un réacteur CVD constitué par un dispositif "InJect" précité, couplé à une enceinte de dépôt chimique en phase vapeur. Ledit dispositif "InJect" comprend quatre parties principales : le réservoir de stockage de la solution, un injecteur relié par une ligne d'alimentation au réservoir de stockage et muni d'un dispositif de commande électronique, une ligne d'alimentation en gaz vecteur ou porteur neutre (par exemple l'azote) et un évaporateur. L'enceinte de dépôt chimique en phase vapeur, qui contient le substrat à revêtir, comprend des moyens de chauffage, une alimentation en oxygène ou en hydrogène, et des moyens de pompage et de régulation de la pression réduite. L'évaporateur est connecté à l'enceinte de dépôt chimique en phase vapeur par une canalisation qui est munie de moyens de chauffage et qui est maintenue à la même température que l'évaporateur. L'enceinte de dépôt chimique en phase vapeur et le substrat à revêtir qui y est placé sont maintenus à une température supérieure à celle de l'évaporateur. La solution de précurseur d'argent est introduite dans le réservoir maintenu à une pression de 1 bar, puis propulsée à partir dudit réservoir grâce à l'injecteur par différence de pression dans l'évaporateur qui est maintenu sous vide. Le débit d'injection est contrôlé par l'injecteur que l'on peut considérer comme une microélectrovanne et qui est commandé par un ordinateur.

### Exemple 1

A l'aide d'une solution de mésitylène-diisopropylamine contenant 1,25% en volume de diisopropylamine et 0,03 mol/l de pivalate d'argent, on a déposé un film d'argent sur un substrat placé dans l'enceinte de dépôt à 250°C sous une pression de 7,5 Torr. La solution de pivalate est évaporée à 150°C et envoyée dans l'évaporateur avec un débit de 16 ml/h, en même temps que de l'oxygène gazeux avec un débit de 6 ml/min (O₂/N₂ = 0,075) et de l'azote avec un débit 80 ml/min.

Deux échantillons ont été préparés selon ce procédé, l'un avec un substrat monocristallin de MgO, l'autre avec un substrat monocristallin de LaAlO₃.

Pour les deux échantillons, on a obtenu un film d'argent adhérent de bonne qualité avec une épaisseur de 320-365 nm.

Les figures 1a et 1b représentent les clichés de Microscopie Electronique à Balayage (MEB) de la surface du dépôt d'Ag obtenu sur le substrat MgO sous différents grossissement.

Les figures 2a et 2b représente les clichés de Microscopie Electronique à Balayage (MEB) de la surface du dépôt d'Ag obtenu sur le substrat LaAlO₃ sous différents grossissements.

La figure 3 représente le diagramme de diffraction des RX du dépôt obtenu sur le substrat monocristallin de MgO. N représente le nombre de coups, en unités arbitraires. 2θ représente l'angle de diffraction, en degrés.

### Exemple 2

On a reproduit le mode opératoire décrit dans l'exemple 1, en remplaçant la diisopropylamine par la n-hexylamine, respectivement avec un substrat monocristallin de MgO, et avec un substrat monocristallin de LaAlO₃.

Pour les deux échantillons, on a obtenu un film d'argent adhérent de bonne qualité avec une épaisseur d'environ 300 nm.

### Exemple 3

A l'aide d'une solution de mésitylène-diisopropylamine contenant 12,08% en volume de diisopropylamine et 0,05 mol/l de pivalate d'argent, on a déposé un film d'argent sur un substrat monocristallin de Si maintenu à 300°C et placé dans l'enceinte de dépôt à 150°C sous une pression de 7,5 Torr. La solution de pivalate a été évaporée à 150°C et envoyée dans l'évaporateur avec un débit de 8,5 ml/h, en même temps que de l'hydrogène gazeux avec un débit de 30 ml/min (H₂/N₂ = 0,13) et de l'azote avec un débit 230 ml/min.

Un film d'argent ayant une épaisseur de 250 nm a été déposé en 35 minutes, avec une vitesse de croissance de 0,43 µm/h.

### Exemple 4

A l'aide d'une solution de mésitylène-diisopropylamine contenant 2,5% en volume de diisopropylamine et 0,06 mol/l de pivalate d'argent, on a déposé un film d'argent sur un substrat maintenu à 320°C et placé dans l'enceinte de dépôt à 150°C sous une pression de 7,5 Torr. La solution de pivalate a été évaporée à 150°C et envoyée dans l'évaporateur avec un débit de 37 ml/h, en même temps que de l'oxygène gazeux avec un débit de 71 ml/min (O₂/N₂ = 0,8875) et de l'azote avec un débit 80 ml/min.

Deux échantillons ont été préparés selon ce procédé, l'un avec un substrat monocristallin de Si, l'autre avec un substrat SiO₂/Si. Un film d'argent ayant une épaisseur de 150 nm a été déposé en 8 minutes, avec une vitesse de croissance de 1,125 microns/h.

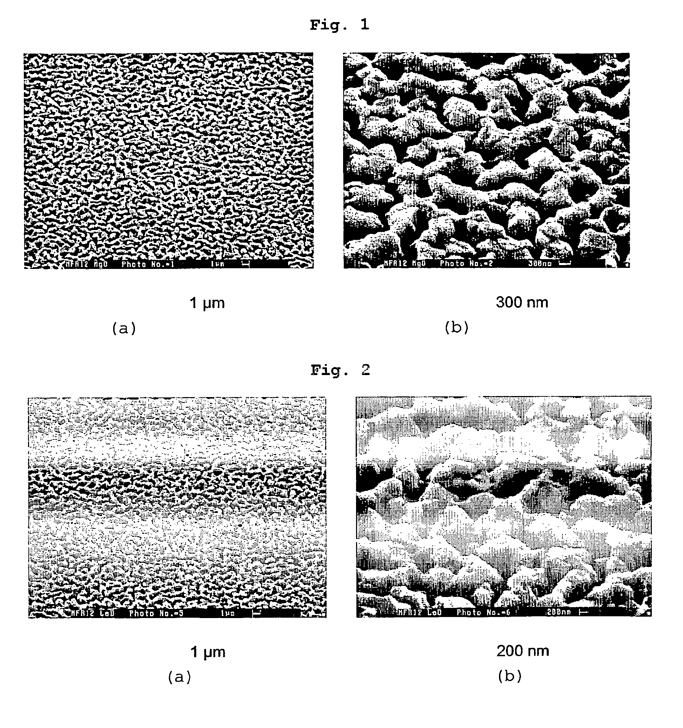

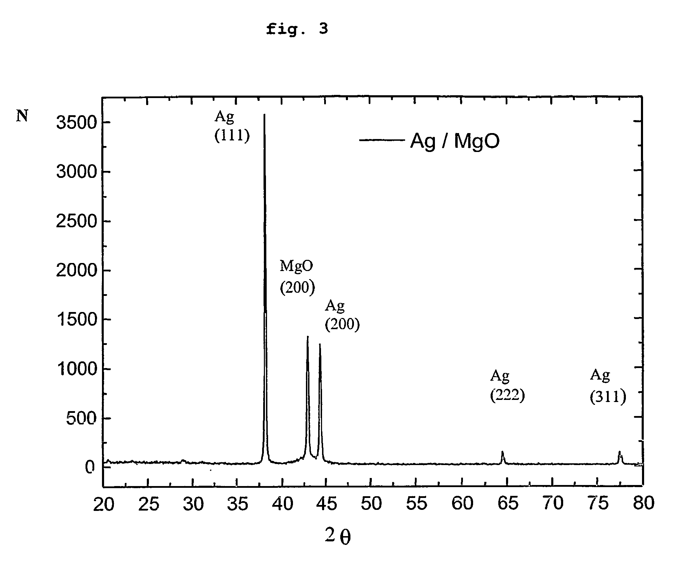

Pour les films obtenus dans les exemples 2 à 4, l'aspect des clichés de Microscopie Electronique à Balayage (MEB) de la surface du dépôt d'Ag est identique à ceux qui sont reproduits sur les figures 1a, 1b, 2a et 2b.

## Revendications

1. Procédé de dépôt d'un film d'argent sur un substrat, consistant à effectuer un dépôt d'argent par CVD sur ledit substrat à l'aide d'une solution de précurseur d'argent, **dans lequel :**
- le précurseur d'argent est un carboxylate d'argent RCO₂Ag dans lequel R est un radical alkyle linéaire ou ramifié ayant de 3 à 7 atomes des carbone, utilisé sous forme d'une solution dans un liquide organique ;
- la concentration en précurseur de la solution est entre 0,01 et 0,6 mol/l, **et elle reste inférieure à la concentration à saturation** ;
- Le liquide organique comprend une amine et/ou un nitrile, et éventuellement un solvant dont la température d'évaporation est inférieure à la température de décomposition du précurseur ;
- le pourcentage en volume de l'amine et/ou du nitrile dans le liquide organique est supérieur à 0,1 % ;
**ledit procédé étant caractérisé en ce qu'il est mis en oeuvre sous atmosphère d'oxygène ou sous atmosphère d'hydrogène.**

2. Procédé selon la revendication 1, **caractérisé en ce que** le précurseur d'argent est le pivalate d'argent (CH₃)₃-C-CO₂Ag.

3. Procédé selon la revendication 1, **caractérisé en ce que** le solvant est un composé organique liquide à température ambiante et jusqu'à environ 200°C dans les conditions normales de pression.

4. Procédé selon la revendication 3, **caractérisé en ce que** le solvant est choisi parmi le mésitylène, le cyclohexane, le xylène, le toluène et le n-octane.

5. Procédé selon la revendication 1, **caractérisé en ce que** l'amine est une monoamine choisie parmi la n-hexylamine, l'isobutylamine, la disecbutylamine, la triéthylamine, la benzylamine, l'éthanolamine et la diisopropylamine.

6. Procédé selon la revendication 1, **caractérisé en ce que** l'amine est une polyamine.

7. Procédé selon la revendication 1, **caractérisé en ce que** le nitrile est choisi parmi l'acétonitrile, le valéronitrile, le benzonitrile et le propionitrile.

8. Procédé selon la revendication 1, **caractérisé en ce que** le substrat est formé par un matériau choisi parmi les matériaux supraconducteurs à haute T_{c}, les céramiques, les polymères thermorésistants, les verres, MgO, LaAlO₃, Ni, Si, AsGa, InP, SiC et SiGe.

9. Procédé selon la revendication 1, **caractérisé en ce que** la température du substrat à revêtir est entre 200 et 450°C.

10. Procédé selon la revendication 1, **caractérisé en ce qu'**un plasma froid est ajouté autour du substrat.

## Claims

1. Process for deposition of a silver film on a substrate, consisting in carrying out a deposition of silver by CVD on said substrate using a silver precursor solution, wherein :
- the silver precursor is a silver carboxylate RCO₂Ag in which R is a linear or branched alkyl radical that has 3 to 7 carbon atoms, used in the form of a solution in an organic liquid;
- the concentration of precursor in the solution is between 0.01 and 0.6 mol/l, and remains less than the saturation value;
- the organic liquid comprises an amine and/or a nitrile, and optionally a solvent whose evaporation temperature is less than the decomposition temperature of the precursor;
- the percentage by volume of the amine and/or the nitrile in the organic liquid is more than 0.1 %.
said process being **characterized in that** it is implemented under oxygen atmosphere or under hydrogen atmosphere.

2. Process according to claim 1, wherein the silver precursor is the silver pivalate (CH₃)₃-C-CO₂Ag.

3. Process according to claim 1, wherein the solvent is an organic compound that is liquid at ambient temperature and up to about 200°C under normal pressure conditions.

4. Process according to claim 3, wherein the solvent is selected from mesitylene, cyclohexane, xylene, toluene and n-octane.

5. Process according to claim 1, wherein the amine is a monoamine that is selected from among n-hexylamine, isobutylamine, disec-butylamine, triethylamine, benzylamine, ethanolamine and diisopropylamine.

6. Process according to claim 1, wherein the amine is a polyamine.

7. Process according to claim 1, wherein the nitrile is selected from among acetonitrile, valeronitrile, benzonitrile and propionitrile.

8. Process according to claim 1, wherein the substrate is formed by a material that is selected from among the superconductive high T_{c} materials, the ceramics, the thermoresistant polymers, the glasses, MgO, LaAlO₃, Ni, Si, AsGa, InP, SiC and SiGe.

9. Process according to claim 1, wherein the temperature of the substrate to be coated is between 200 and 450°C.

10. Process according to claim 1, wherein a cold plasma is added around the substrate.

## Patentansprüche

1. Verfahren zur Abscheidung eines Silberfilms auf einem Substrat, das darin besteht, eine Silberabscheidung mittels CVD auf dem Substrat unter Einsatz einer Silbervorläuferlösung durchzuführen, wobei:
- der Silbervorläufer ein Silbercarboxylat RCO₂Ag ist, worin R ein unverzweigter oder verzweigter Alkylrest mit 3 bis 7 Kohlenstoffatomen ist, das in Form einer Lösung in einer organischen Flüssigkeit eingesetzt wird;
- die Konzentration des Vorläufers in der Lösung zwischen 0,01 und 0,6 mol/l beträgt und unter der Sättigungskonzentration bleibt;
- die organische Flüssigkeit ein Amin und/oder ein Nitril umfasst, sowie gegebenenfalls ein Lösungsmittel, dessen Verdampfungstemperatur niedriger ist als die Zersetzungstemperatur des Vorläufers;
- der Volumsprozentsatz des Amins und/oder Nitrils in der organischen Flüssigkeit mehr als 0,1 % beträgt;
wobei das Verfahren **dadurch gekennzeichnet ist, dass** es unter Sauerstoff- oder Wasserstoffatmosphäre durchgeführt wird.

2. Verfahren nach Anspruch 1, **dadurch gekennzeichnet, dass** der Silbervorläufer Silberpivalat (CH₃)₃-C-CO₂Ag ist.

3. Verfahren nach Anspruch 1, **dadurch gekennzeichnet, dass** das Lösungsmittel eine organische Verbindung ist, die bei Raumtemperatur bis etwa 200 °C unter Normaldruckbedingungen flüssig ist.

4. Verfahren nach Anspruch 3, **dadurch gekennzeichnet, dass** das Lösungsmittel aus Mesitylen, Cyclohexan, Xylol, Toluol und n-Octan ausgewählt wird.

5. Verfahren nach Anspruch 1, **dadurch gekennzeichnet, dass** das Amin ein Monoamin, ausgewählt aus n-Hexylamin, Isobutylamin, Di-sec-butylamin, Triethylamin, Benzylamin, Ethanolamin und Diisopropylamin ist.

6. Verfahren nach Anspruch 1, **dadurch gekennzeichnet, dass** das Amin ein Polyamin ist.

7. Verfahren nach Anspruch 1, **dadurch gekennzeichnet, dass** das Nitril aus Acetonitril, Valeronitril, Benzonitril und Propionitril ausgewählt wird.

8. Verfahren nach Anspruch 1, **dadurch gekennzeichnet, dass** das Substrat aus einem Material besteht, das aus supraleitenden Materialien mit hoher T_{c}, Keramiken, wärmebeständigen Polymeren, Gläsern, MgO, LaAlO₃, Ni, Si, AsGa, InP, SiC und SiGe ausgewählt wird.

9. Verfahren nach Anspruch 1, **dadurch gekennzeichnet, dass** die Temperatur des zu beschichtenden Substrats zwischen 200 und 450 °C beträgt.

10. Verfahren nach Anspruch 1, **dadurch gekennzeichnet, dass** ein Kaltplasma rund um das Substrat zugesetzt wird.
